# DEMANDE DE BREVET EUROPEEN

(11) **EP 0 993 047 A1**
(43) Date de publication de la demande: **12.04.2000**
(21) Numéro de dépôt: 99203175.7
(22) Date de dépôt: 29.09.1999
(51) Int. Cl.: H01L 27/06, H01L 23/00

(54) **Dispositif semi-conducteur avec des éléments de circuits intégrés du groupe III-V ayant des moyens pour prévenir la pollution par l'hydrogène**

(30) Priorité: 06.10.1998 FR 9812497
(71) Demandeur: Koninklijke Philips Electronics N.V., 5621 BA Eindhoven (NL)
(72) Inventeur: Baudet, Pierre, 75008 Paris (FR); Frijlink, Peter, 75008 Paris (FR)
(74) Mandataire: Lottin, Claudine

(57) **Abrégé**

Dispositif semiconducteur comprenant des éléments de circuits intégrés réalisés au moyen d'un empilement de couches de matériaux semiconducteurs réalisé sur un substrat en matériau semiconducteur et ayant des moyens pour prévenir la pollution des éléments de circuits et du substrat par l'hydrogène provenant de leur environnement, caractérisé en ce que ces moyens consistent en une couche d'un matériau absorbeur d'hydrogène appelée piège à hydrogène (10) qui forme un motif intégré avec les éléments de circuit et dont la surface extérieure (11) est exposée et en contact avec l'environnement.

Ce dispositif de type MMIC est compris dans un module d'un système de télécommunication spatial ou terrestre.

Application : systèmes de télécommunication spatiaux ou terrestres.

## Description

L'invention concerne un dispositif semi-conducteur comprenant des éléments de circuit intégrés réalisés dans un empilement de couches sur un substrat et ayant des moyens pour prévenir la pollution des éléments de circuit et du substrat par l'hydrogène provenant de leur environnement.

L'invention trouve son application dans l'industrie de fabrication de dispositifs semiconducteurs incluant des circuits intégrés et incorporés dans des modules étanches, tels que les modules de transmission utilisés dans le domaine des télécommunications.

Un dispositif semiconducteur ayant des moyens pour prévenir la pollution d'éléments de circuit par l'hydrogène est déjà connu de la demande de brevet JP N° 64-207266 du 10.08.1989 publiée le 27.03.1991 (FUJITSU LTD ; TAKAYUKI OBA). Cette demande de brevet décrit des moyens pour empêcher l'hydrogène de diffuser dans le substrat semiconducteur et pour améliorer la fiabilité d'un dispositif semiconducteur. Ces moyens consistent en une couche qui absorbe l'hydrogène contenu dans des couches isolantes.

La mise en oeuvre de ces moyens comprend la réalisation d'un film composite consistant en une couche métallique réalisée en un métal qui absorbe l'hydrogène pour faire un hydrure, disposée en sandwich entre deux couches isolantes de nitrure de silicium (SiN). Ce film composite est déposé à la surface supérieure d'un dispositif semiconducteur comprenant un substrat et un élément de circuit formé sur ce substrat. La couche isolante qui contient de l'azote (N) telle que la couche de nitrure de silicium (SiN) contient beaucoup d'hydrogène. La couche métallique qui est en sandwich entre les couches isolantes absorbe cet hydrogène. Un métal approprié à absorber l'hydrogène est le palladium. Comme exemple, le film composite est constitué de la couche métallique formée de palladium en sandwich entre deux couches de nitrure de silicium. Il en résulte que l'hydrogène qui est présent à l'intérieur d'une couche isolante de protection formée en surface supérieure du dispositif semiconducteur et l'hydrogène qui est présent à l'intérieur d'une couche isolante intermédiaire peut être capturé par la couche métallique en sandwich. La diffusion de l'hydrogène dans le substrat est ainsi supprimée et la génération d'électrons chauds dans le substrat peut être minimisée.

Un but de la présente invention est de fournir des moyens pour éliminer l'hydrogène provenant plus particulièrement de l'environnement d'un dispositif semiconducteur intégré lorsque ce dispositif semiconducteur est protégé par un boîtier. Il est connu de l'homme du métier que les parties métalliques des boîtiers de protection des "puces" ou dispositifs semiconducteurs intégrés vieillissent en dégazant notamment de l'hydrogène. Lorsque le dispositif semiconducteur est réalisé sur un substrat en un matériau du groupe III-V, par exemple l'arséniure de gallium, l'hydrogène réagit avec le matériau du substrat et agit comme un neutralisateur de charges, soit à la surface, soit à l'intérieur du matériau même. Lorsque le dispositif semiconducteur comprend un empilement de couches épitaxiales en l'un de ces matériaux du groupe III-V, l'hydrogène agit comme un neutralisateur de charge aux interfaces des couches ou à l'intérieur des couches. La diffusion d'hydrogène a donc un rôle néfaste important sur les charges de surface, d'interfaces et sur les profils de dopage du substrat et des couches.

Ce phénomène est généralement appelé pollution par l'hydrogène (en anglais : hydrogen poisoning). Son effet peut apparaître à des températures de l'ordre de 100°C et plus haut. Il faut savoir que dans le domaine des circuits intégrés, les normes d'utilisation peuvent exiger que le circuit travaille sans détérioration de ses performances jusqu'à 125°C, ou bien jusqu'à 200 ou 300°C selon l'utilisation envisagée. En particulier, un circuit inclus dans un module embarqué sur un satellite de télécommunication doit pouvoir travailler à des températures de l'ordre de 300°. Or il apparaît que dès qu'un dispositif semiconducteur du type décrit plus haut est enfermé dans un boîtier de protection, ce dispositif semiconducteur voit ses performances détérioriées en des temps très courts de l'ordre de quelques centaines d'heures ou même de seulement quelques heures selon la température à laquelle il est amené à travailler. Des essais ont montré que l'utilisation d'une couche métallique en un métal absorbant l'hydrogène disposée en sandwich entre deux couches isolantes pour former un film composite couvrant les circuits intégrés à un rôle néfaste sur ce circuit intégré car ce film composite forme une forte capacité parasite qui détériore les performances de tous les éléments du circuit intégré même à température ambiante. Une telle couche réalisée comme enseigné par la demande de brevet citée doit donc absolument être évitée.

Selon le document cité, l'enseignement était que l'hydrogène provenait des couches isolantes elles-mêmes. Des expériences ont été menées pour vérifier la présence de ce problème et ces expériences ont montré que l'effet produit était négligeable. Par contre, l'hydrogène provenant de l'environnement du dispositif semiconducteur et notamment du boîtier produit un effet néfaste très important.

Selon l'invention cet effet néfaste est supprimé par un dispositif muni des moyens récités dans la revendication 1.

Un avantage du dispositif selon l'invention est que, une fois que ce dispositif est enfermé dans un boîtier, l'effet néfaste de l'hydrogène sur les éléments de circuits intégrés n'est plus constaté. La détérioration des performances des circuits intégrés n'est plus sensible dans le temps. D'où il résulte que l'hydrogène contenu dans le circuit intégré lui-même n'est pas le facteur de détérioration majeure tel qu'enseigné par la demande de brevet cité. En tout état de cause, les moyens de l'invention résolvent aussi le problème connu de la demande de brevet citée.

L'invention est décrite ci-après en détail en référence aux figures schématiques annexées incluant :
la FIG.1A qui représente vu du dessus un dispositif semiconducteur avec un exemple d'élément de circuit intégré sur un substrat muni d'un piège pour l'hydrogène (getter) ;
la FIG.1B qui représente le dispositif de la FIG.1 en coupe,
les FIGS.2A, 2B, 2C qui illustrent des étapes d'un procédé de réalisation d'un piège pour l'hydrogène inclut dans un circuit intégré d'un dispositif semiconducteur.

L'invention concerne un dispositif semiconducteur intégré comprenant des éléments de circuits réalisés dans un empilement de couches sur un substrat en matériaux du groupe chimique III-V. Ces matériaux du groupe III-V perdent en peu d'heures leurs propriétés électriques lorsqu'ils se trouvent dans un environnement contenant de l'hydrogène et à une température supérieure à la température ambiante.

L'invention propose des moyens intégrés avec les éléments de circuit sur le substrat pour éliminer l'hydrogène provenant de l'environnement.

Par hydrogène de l'environnement, on entend l'hydrogène qui est enfermé avec le dispositif intégré à l'intérieur d'un boîtier de protection étanche. L'hydrogène contenu dans ledit environnement provient essentiellement des éléments métalliques du boîtier qui dégazent au cours du temps sous l'effet du vieillissement ou de la température supérieure à l'ambiante.

Par température supérieure à l'ambiante, on entend des températures par exemple comprises entre 30°C et 300°C qui peuvent survenir lorsque le dispositif est utilisé dans un système embarqué sur satellite ou utilisé de manière terrestre pour des applications en télécommunication. Plus généralement, les températures de travail sont de l'ordre de 100°C à 250°C.

Dans ces conditions, il a été trouvé que l'hydrogène en cause ne provenait pas de manière appréciable de parties de circuits intégrés, ou de couches isolantes du circuit intégré, mais à la différence, du dégazage de parties métalliques ou autres du boîtier et que ce dégazage est encore présent même lorsque le boîtier a déjà été dégazé avant son utilisation.

Selon l'invention, on dispose sur une partie de la surface du circuit intégré, une partie de couche d'un matériau qui absorbe l'hydrogène. Cette partie de couche qui peut avoir n'importe quelle forme est réalisée dans les parties vides d'éléments de circuits, par exemple entre des éléments de circuit, ou bien en périphérie des circuits intégrés en tenant compte des contraintes de fabrication qui donnent les distances entre des éléments de circuits.

Comme matériau qui absorbe l'hydrogène, à ce jour, le palladium (Pd) est un métal qui donne les meilleurs résultats. Il n'est pas exclu que l'homme du métier trouve d'autres matériaux ou métaux ayant d'aussi bonnes performances. Dans ce cas, ces matériaux ou métaux peuvent être utilisés comme le palladium. On connaît aussi le titane (Ti) seul ou en combinaison avec le palladium (Pd) qui donne des résultats convenables. D'une manière générale, des matériaux comprenant du palladium ou bien des matériaux comprenant du titane, ou bien les deux sont favorablement employés pour réaliser un piège à hydrogène.

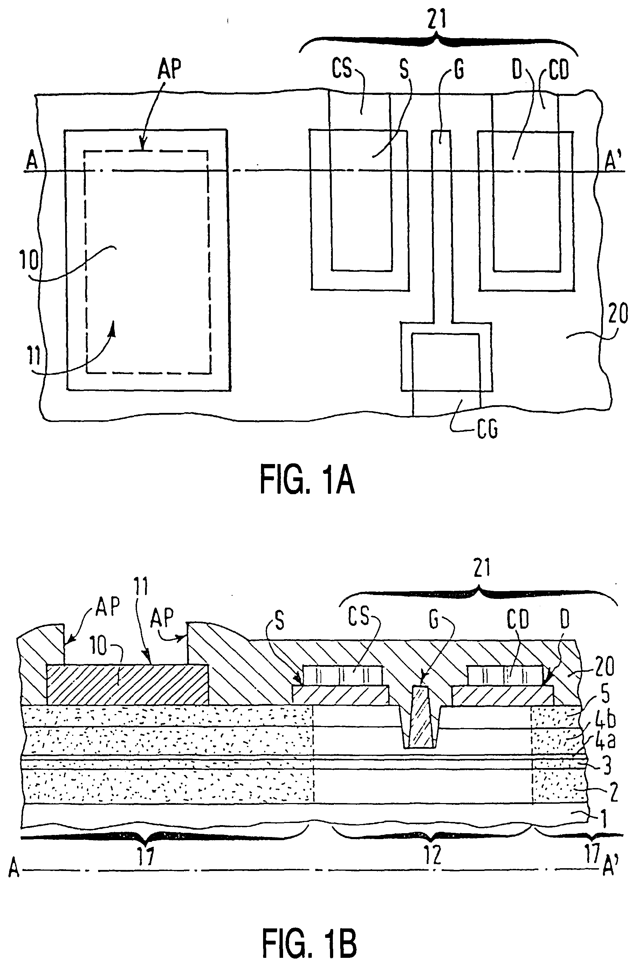

En référence à la FIG.1A, on montre à titre d'exemple de réalisation, vu du dessus, un dispositif semiconducteur avec un élément de circuit intégré 21 et un motif 10 en un matériau absorbeur d'hydrogène. L'élément de circuit intégré 21 est un transistor à effet de champ avec une grille G, une source S et un drain D. Le motif 10 en matériau absorbeur d'hydrogène est un rectangle. Mais ce motif pourrait avoir n'importe quelle forme pour s'insérer entre les éléments de circuit.

En référence à la FIG.1B, on montre le même dispositif semiconducteur en coupe selon l'axe AA' de la FIG.1A. Le dispositif semiconducteur comporte un empilement de couches 2 à 5 du groupe III-V réalisées sur un substrat 1 en arséniure de gallium (GaAs). L'empilement des couches comporte des régions 17 pour isoler latéralement un élément de circuit d'autres éléments de circuit, et au moins une région 12 active pour réaliser un élément de circuit qui dans l'exemple donné est un transistor PHEMT (de l'anglais Pseudomorphic High Electron Mobility Transistor) ou HEMT pseudomorphique.

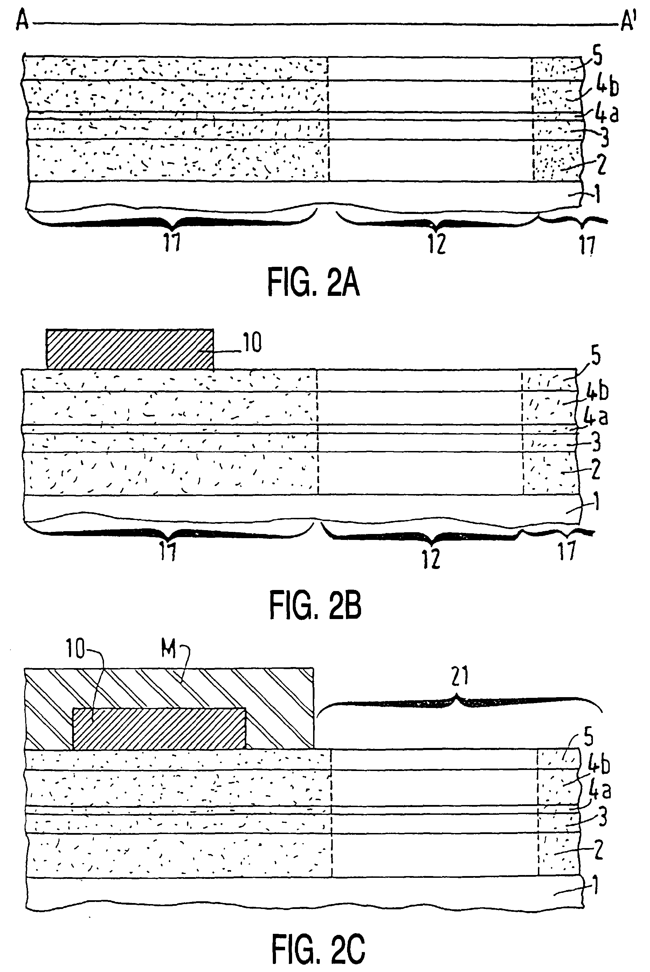

La FIG.2A représente à titre d'exemple non limitatif, un empilement de couches épitaxiales réalisées sur un substrats semi-isolant 1 en GaAs pour réaliser un PHEMT. Cet empilement comporte à partir du substrat : une couche tampon 2 en GaAs non dopé d'épaisseur de l'ordre de 0,5 à 1 µm ; deux couches adjacentes formant une hétérostructure, c'est-à-dire ayant des largeurs de bande interdite (en anglais : GAP) différentes, avec la couche 3 en InGaAs non dopée de plus faible largeur de bande interdite et d'épaisseur de l'ordre de 10 à 15 nm et avec la couche 4 en AlGaAs dopée n⁺ d'épaisseur environ 20 à 50 nm ; puis la couche de couverture 5 en GaAs dopée n+ d'épaisseur environ 20 à 50 nm. La couche 4 constitue une couche d'arrêt de gravure vis-à-vis de la couche 5.

Dans une étape suivant la réalisation des couches, une implantation d'ions est réalisée dans les zones 17 pour délimiter la région active 12.

En référence à la FIG.2B, une couche 10, par exemple en palladium est ensuite réalisée de manière à former le motif absorbeur d'hydrogène de la forme prédéterminée (par exemple un rectangle entre deux transistors).

En référence à la FIG.2C, le motif est ensuite protégé par un masque M en un matériau qui permet de réaliser le transistor dans la région 21 par les méthodes standards connues de l'homme du métier et qui peut être éliminé lorsque le transistor est terminé.

En référence à la FIG.1B, le masque M de protection du motif 10 a été éliminé, le transistor 21 étant achevé, et l'ensemble du dispositif semiconducteur est couvert d'une couche de protection qui peut être en silice (Si0₂) ou en nitrure de silicium (SiN).

La FIG.1B associée à la FIG.1A, montre que la grille G, le drain D et la source S sont couverts par des couches conductrices CG, CD et CS respectivement, qui sont appelés contacts de deuxième niveau et qui servent à connecter ces électrodes G, D, S avec d'autres éléments du circuit intégré.

Selon l'invention, une couche de protection 20 couvre tout le circuit intégré, mais il est très important qu'elle comporte une ouverture AP pour exposer la surface supérieure 11 de la couche 10 en matériau absorbant l'hydrogène.

Le circuit intégré muni de la couche 10 pour absorber l'hydrogène n'a pas d'inconvénients de montrer des capacités parasites comme le dispositif décrit au titre d'état de la technique. Une fois le dispositif semiconducteur enfermé dans son boîtier de protection, on constate que les détériorations de performances qui apparaissaient avant que l'on applique le type de piège (en anglais : getter) à hydrogène formé par la couche 10 selon l'invention ne se produisent plus. Ceci semble prouver que le vrai problème se trouvait bien dans la présence d'hydrogène dans l'environnement du dispositif semiconducteur et non pas dans la quantité d'hydrogène certainement négligeable présente dans les couches du circuit intégré lui-même.

La fabrication des transistors ou éléments de circuits MMICs réalisée au moyen de matériaux du groupe III-V comprend parfois l'utilisation de palladium pour isoler des couches d'aluminium (Al) de couches d'or (Au) parce que l'aluminium et l'or sont incompatibles. La réalisation d'une couche 10 de palladium comme piège à hydrogène ne crée pas, dans ce cas, d'étape de réalisation supplémentaire : il suffit de réserver l'emplacement pour le motif 10 de palladium, et de réaliser ensuite ce motif en même temps que les couches d'isolement Al/Au. La couche 10 n'est donc pas obligatoirement formée directement sur le substrat. La seule obligation est que sa surface supérieure 11 doit être exposée.

Le palladium possède la propriété d'absorber environ 900 fois son propre volume d'hydrogène, en formant un composé Pd₂H. Donc la présence d'une couche 10 en palladium de surface et épaisseur suffisamment grande empêche l'hydrogène provenant de l'environnement du circuit d'infester la petite quantité de palladium qui est incluse dans le procédé de fabrication des transistors MMICs en matériaux du groupe III-V. De plus, la présence de la couche 10 formant le piège à hydrogène empêche la neutralisation des charges dans les couches III-V ou à leurs interfaces.

Le dispositif comprenant un ou plusieurs circuits intégrés comme décrit précédemment est enformé dans un boîtier. Le boîtier est de préférence étanche.

Ce dispositif peut être compris dans un module d'un système de télécommunication spatial embarqué sur un satellite artificiel, ou bien dans un module d'un système de télécommunication terrestre.

Les circuits intégrés peuvent constituer des circuits d'émission-réception, des amplificateurs, déphaseurs et tout autre circuit utilisés dans les modules des systèmes de télécommunication. D'une manière générale, ces circuits fonctionnent en hautes et hyperfréquences et sont appelés MMICs (de l'anglais : Monolithic Microwave Integrated Circuits).

## Revendications

1. Dispositif semiconducteur comprenant des éléments de circuits intégrés réalisés au moyen d'un empilement de couches de matériaux semiconducteurs réalisé sur un substrat en matériau semiconducteur et ayant des moyens pour prévenir la pollution des éléments de circuits et du substrat par l'hydrogène provenant de leur environnement, caractérisé en ce que ces moyens consistent en une couche d'un matériau absorbeur d'hydrogène appelée piège à hydrogène (10) qui forme un motif intégré avec les éléments de circuit et dont la surface extérieure (11) est exposée et en contact avec l'environnement.

2. Dispositif selon la revendication 1, caractérisé en ce que la couche piège à hydrogène est formée en surface du substrat et en ce que les éléments de circuits comprennent une couche supérieure de protection qui a une ouverture pour exposer la surface supérieure (11) de ladite couche (10) piège à hydrogène.

3. Dispositif selon la revendication 1, caractérisé en ce que la couche piège à hydrogène est réalisée concomitamment avec une couche constitutive des éléments de circuits intégrés et en un même matériau, et en ce que les éléments de circuits comprennent une couche supérieure de protection qui a une ouverture pour exposer la surface supérieure (11) de ladite couche (10) piège à hydrogène.

4. Dispositif selon la revendication 1, ou selon l'une des revendications 2 ou 3, caractérisé en ce que la couche piège à hydrogène forme des motifs disposés entre les éléments de circuits intégrés ou des motifs disposés à la périphérie des circuits intégrés.

5. Dispositif selon l'une des revendications 1 à 4, caractérisé en ce que les matériaux semiconducteurs sont du groupe chimique III-V.

6. Dispositif selon l'une des revendications 1 à 5, caractérisé en ce que le matériau de la couche piège à hydrogène contient du palladium (Pd).

7. Dispositif selon l'une des revendications 1 à 5, caractérisé en ce que le matériau de la couche piège à hydrogène contient du titane (Ti).

8. Dispositif selon l'une des revendications 1 à 7, caractérisé en ce qu'il est enfermé dans un boîtier.

9. Dispositif selon l'une des revendications 1 à 8, caractérisé en ce qu'il est compris dans un module d'un système de télécommunication spatial embarqué sur satellite.

10. Dispositif selon l'une des revendications 1 à 8, caractérisé en ce qu'il est compris dans un module d'un système de télécommunication terrestre.
